(19) Europäisches Patentamt
European Patent Office
Office européen des brevets

(11) **EP 0 847 015 A1**

(12) **EUROPÄISCHE PATENTANMELDUNG**

(43) Veröffentlichungstag:
10.06.1998 Patentblatt 1998/24

(51) Int. Cl.⁶: $G06F\ 17/17$

(21) Anmeldenummer: 96119505.4

(22) Anmeldetag: 05.12.1996

(84) Benannte Vertragsstaaten:
AT BE CH DE DK ES FI FR GB GR IE IT LI LU MC
NL PT SE
Benannte Erstreckungsstaaten:
AL LT LV RO SI

(71) Anmelder:
Micronas Intermetall GmbH
79108 Freiburg (DE)

(72) Erfinder:
• Menkhoff, Andreas, Dr.
79098 Freiburg (DE)
• Alrutz, Herbert, Dr.rer.nat.
79102 Freiburg (DE)

(54) **Digitale Filterkombination zur Interpolation**

(57) Digitale Filterkombination zur zeitlichen Interpolation von primären Abtastwerten (sp) eines abgetasteten Signals (sg), mit einem zeitdiskreten Filter (1) m-ter Ordnung und einem zeitkontinuierlichen Interpolationsfilter (2) k-ter Ordnung. Das zeitdiskrete Filter (1) bildet aus den primären Abtastwerten (sp) sekundäre Abtastwerte (ss), die zeitlich äquidistanten Abständen (T*, T/2) entsprechen und gleichzeitig dem zeitkontinuierlichen Interpolationsfilter (2) zugeführt sind. Dieses bildet aus diesen sekundären Abtastwerten (ss) einen Interpolationswert (st), dessen zeitliche Lage durch einen normierten Interpolationszeitpunkt $dp = t_{in}/T$ vorgebbar ist, wobei $t_{in}$ der absolute Interpolationszeitpunkt und T die Periodendauer der primären Abtastrate sind.

Fig.3

EP 0 847 015 A1

**Beschreibung**

Die Erfindung betrifft eine digitale Filterkombination zur zeitlichen Interpolation von Abtastwerten eines abgetasteten Signals. Die Abtastwerte müssen dabei ein bandbegrenztes Signal darstellen oder durch ein entsprechendes digitales Filter im Band begrenzt sein. Mittels der Interpolation soll beispielsweise die Abtastrate um ein beliebiges Zahlenverhältnis verändert werden oder unter der Beibehaltung der jeweiligen Abtastrate ein Signalzwischenwert berechnet werden. Derartige Anwendungen ergeben sich bei der Verarbeitung von digitalen Video- und Audiosignalen, insbesondere in digitalen Fernsehempfängern, Videorekordern, Audiowiedergabeeinrichtungen oder Multimedia-Verarbeitungsgeräten auf Rechner- oder Fernsehgerätebasis.

Im einfachsten Fall erfolgt eine derartige Interpolation durch eine lineare Interpolation, die von benachbarten Stützwerten der Abtastfolge ausgeht. Als Nachteil dieser einfachen Interpolation ist bekannt, daß sie Signalfrequenzen mit der halben Abtastfrequenz unterdrückt. Bei Videosignalen verschlechtert sich dadurch der subjektive Bildschärfeeindruck, es kann sogar zu deutlichen Bildstörungen kommen, wenn die Auslöschung zu Interferenzeen bei periodischen Bildinhalten führt.

Aus EP 0 181 953 A (ITT-case: C-DIT-1230) ist ein Interpolator für Digitalsignale bekannt, der ein Teil dieser Nachteile dadurch umgeht, daß er als digitale Filterkombination ausgebildet ist, die in Signalflußrichtung ein zeitdiskretes Interpolationsfilter dritter Ordnung und ein lineares Interpolationsfilter enthält. Das zeitdiskrete Interpolationsfilter bildet dabei zusätzlich zu den vorhandenen Abtastwerten genau in der zeitlichen Abtastmitte einen Zwischenwert. Durch das zeitdiskrete Filter ist gleichsam die Abtastrate verdoppelt worden. Bei dem beschriebenen zeitdiskreten Filter läßt sich der Frequenzgang im Durchlaßbereich für höhere Frequenzen ändern, indem mittels eines Gewichtungsfaktors bestimmte Frequenzanteile vergrößert oder verkleinert werden können. Mittels einer Verzögerungskette aus drei Verzögerungsstufen und der logischen Verknüpfung der unterschiedlich verzögerten Abtastwerte werden die einzelnen Frequenzkomponenten gebildet, die gegebenenfalls mittels Multiplizierern unterschiedlich gewichtet und schließlich kombiniert werden. Aus der neuen Abtastfolge wird mittels der nachfolgenden linearen Interpolation dann zu dem gewünschten Interpolationszeitpunkt der Interpolationswert aus den beiden nächstliegenden sekundären Abtastwerten berechnet. Für die Durchführung der linearene Interpolation wird in dem angegebenen Beispiel lediglich ein Subtrahierer, ein Multiplizierer und ein Addierer benötigt` wobei das Mischungsverhältnis aus den beiden Abtastwerten durch den Multiplizierer und einen zugeführten Multiplikationsfaktor gesteuert ist. Der Multiplikationsfaktor entspricht dabei einem auf die sekundäre Abtastrate normierten Interpolationszeitpunkt.

Die Filterfunktion dieser Filterkombination entspricht jedoch nicht mehr den gesteigerten Anforderungen an eine digitale Interpolation. Es ist daher Aufgabe der Erfindung, ein verbessertes digitales Filter zur beliebigen zeitlichen Interpolation eines abgetasteten Signals anzugeben, das insbesondere bei digitalisierten Videosignalen eine verbesserte Bildwiedergabe ermöglicht.

Die Aufgabe wird nach der Erfindung durch eine digitale Filterkombination gelöst, deren Merkmale im Anspruch 1 wie folgt angegeben sind:

- digitale Filterkombination zur zeitlichen Interpolation von primären Abtastwerten eines abgetasteten Signals, mit einem zeitdiskreten Filter m-ter Ordnung und einem zeitkontinuierlichen Interpolationsfilter k-ter Ordnung, wobei m $\geq$ 3 und k $\geq$ 2 ist,

- das zeitdiskrete Filter bildet aus mindestens m + 1 primären Abtastwerten in zeitlich äquidistanten Abständen n sekundäre Abtastwerte, dabei ist n $\geq$ m, und

- das zeitkontinuierliche Interpolationsfilter bildet aus mindestens einem Teil der n sekundären Abtastwerte einen Interpolationswert, dessen zeitliche Lage bezüglich derjenigen der primären Abtastwerte durch einen normierten Interpolationszeitpunkt dp = $t_{in}$ /T vorgebbar ist, wobei $t_{in}$ der absolute Interpolationszeitpunkt und T die Periodendauer der primären Abtastrate sind.

Die Erfindung geht von der Erkenntnis aus, daß die Aufgabe mit einer digitalen Filterkombination aus einem zeitdiskreten Filter, zur Berechnung fester Zwischenabtastwerte, und einem zeitkontinuierlichen Filter, zur Berechnung beliebiger Zwischenwerte, realisiert werden kann. Die Verwendung einer derartigen Kombination ist von Vorteil, weil die beiden Filterteile unabhängig voneinander optimiert werden können.

Wird gegenüber der aus EP 0 181 953 bekannten Schaltung ein zeitdiskretes Filter mit vierter oder höherer Ordnung zur Berechnung der festen Zwischenabtastwert benutzt, so hätte dies den Vorteil, daß der Amplitudengang zwar einen günstigeren Verlauf aufweisen würde, aber den Nachteil, daß sich aufgrund der über viele Abtastwerte erstreckenden Impulsantwort das Ein- und Ausschwingen des zeitdiskreten Filters sich ebenfalls über viele Abtastwerte erstrecken würde, was die Interpolation sehr stören würde. Daher wird die Ordnung des zeitdiskreten Filters nicht geändert. Anstelle der linearen Interpolation, die einer Interpolation erster Ordnung entspricht, wird jedoch in dem zeitkontinuierlichen Filter mindestens eine Interpolation zweiter Ordnung verwendet. Dabei ist das Interpolationspolynom so entworfen, daß es als monolithisch integrierbare Schaltung zusammen mit dem zeitdiskreten Filter einfach implementierbar ist. Für die kombinierte Filterschaltung ist es unerheblich, in wieweit einige Funktionseinheiten als eigene Schaltungsblöcke implementiert sind oder mittels eines Programms innerhalb eines Prozessors realisiert sind.

Die Erfindung und vorteilhafte Ausgestaltungen werden nun anhand der Figuren der Zeichnung näher erläutert:

Fig. 1 zeigt schematisch als Blockschaltbild ein einfaches Ausführungsbeispiel für eine digitale Filterkombination nach der Erfindung,

Fig. 2 und Fig. 3 zeigen im Zeitdiagramm schematisch eine primäre bzw. sekundäre Abtastfolge und

Fig. 4 und Fig. 5 zeigen im Zeitdiagramm die Auswahl der Stützwerte bei unterschiedlichen Interpolationszeitpunkten.

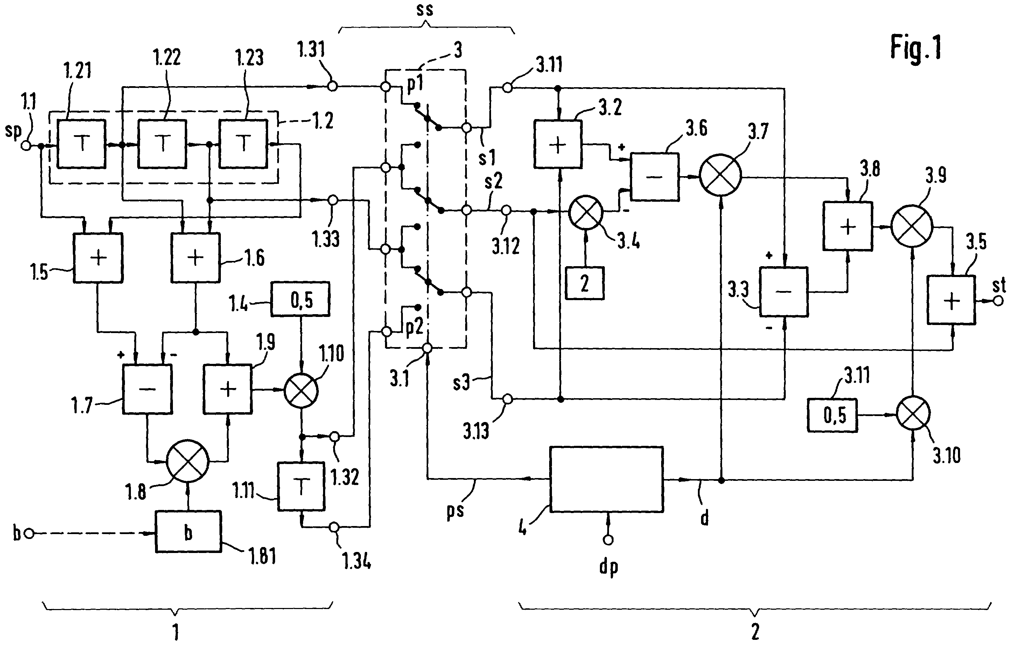

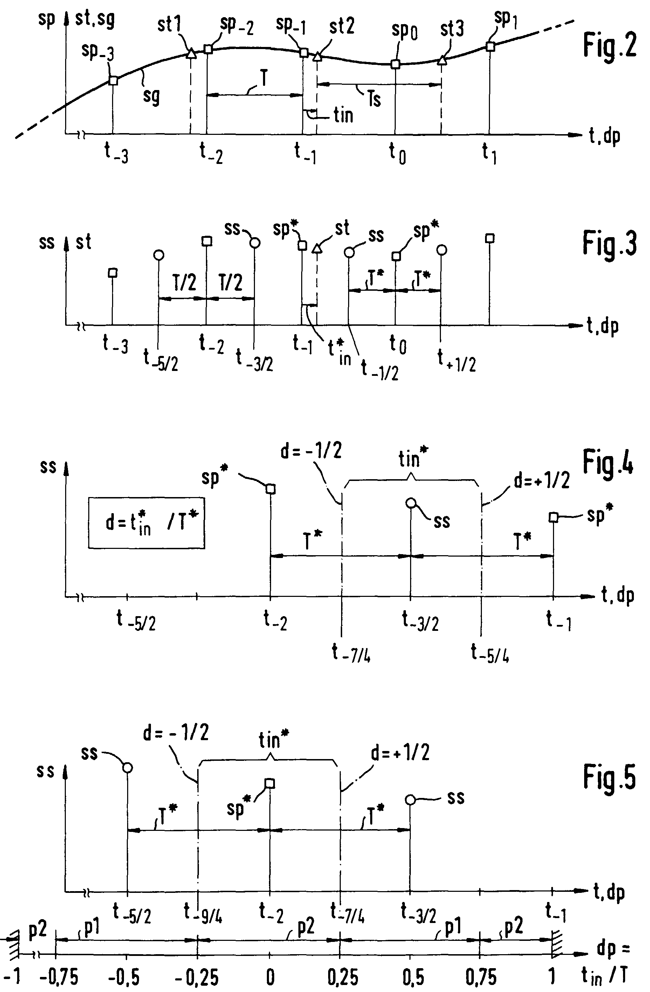

Das in Fig. 1 dargestellte Interpolationsfilter enthält eingangsseitig ein zeitdiskretes Filter 1 und ausgangsseitig ein zeitkontinuierliches Interpolationsfilter 2. Die Verkopplung zwischen beiden Filtern bildet ein Mehrfachumschalter 3, dessen Steuereingang 3.1 von einer Steuereinrichtung 4 gespeist ist, die ein Umschaltsignal ps in Abhängigkeit von einem vorgegebenen normierten Interpolationszeitpunkt dp bildet. Einem Eingang 1.1 des zeitdiskreten Filters 1 sind primäre Abtastwerte sp zugeführt, deren Bandbreite durch die Bandbreite des usrsprünglichen Signals sg (siehe Fig. 2) und das Nyquistkriterium begrenzt ist. An den Eingang 1.1 schließt sich eine Verzögerungskette 1.2 aus drei Verzögerungsstufen 1.3, 1.4, 1.5 an, deren jeweilige Verzögerungszeit der Periodendauer T des Digitalisierungstaktes der primären Abtastwerte sp gleich ist. Durch unterschiedliche Verknüpfung der an der Verzögerungskette 1.2 abgegriffenen primären Abtastwerte sp werden die einzelnen Frequenzkomponenten zur Bildung sekundärer Abtastwerte ss gebildet. Das in Fig. 1 dargestellte Ausführungsbeispiel des zeitdiskreten Filters 1 zeichnet sich dadurch aus, daß es nur einen einzigen echten Multiplizierer 1.8 und nur vier Verzögerungsstufen und vier Addierer/Subtrahierer erfordert. Die Schaltungskonfiguration mit der dreistufigen Verzögerungskette 1.2 entspricht einem zeitdiskreten Filter dritter Ordnung, wobei ein solches selbstverständlich auch auf andere Weise implementiert werden kann.

Der Eingang der ersten Verzögerungsstufe 1.3 liegt am ersten Eingang eines ersten Addierers 1.5, und deren Ausgang am ersten Eingang eines zweiten Addierers 1.6, mit dessen zweitem Eingang der Eingang der dritten Verzögerungsstufe 1.5 verbunden ist, deren Ausgang am zweiten Eingang des ersten Addierers 1.5 liegt. Der Ausgang des ersten Addierers 1.5 ist mit dem Minuend-Eingang und der Ausgang des zweiten Addierers 1.6 mit dem Subtrahend-Eingang eines ersten Subtrahierers 1.7 verbunden, dessen Ausgang über einen ersten Multiplizierer 1.8 mit dem ersten Eingang eines dritten Addierers 1.9 verbunden ist, dessen zweiter Eingang am Ausgang des zweiten Addierers 1.6 und dessen Ausgang über einen zweiten Multiplizierer 1.10 an einem zweiten Ausgang 1.32 und über eine vierte Verzögerungsstufe 1.11, die eine Verzögerung um die Periodendauer T des primären Abtasttaktes bewirkt, an einem vierten Ausgang 1.34 des zeitdiskreten Filters 1 liegt. Am zweiten und vierten Ausgang 1.32 bzw. 1.34 werden diejenigen interpolierten Abtastwerte abgegriffen, die genau zwischen den primären Abtastzeitpunkten liegen, also zu den normierten Zeitpunkten dp = + 1/2 bzw. dp = - 1/2, das entspricht den absoluten Zeitpunkten $t = t_{-3/2}$ bzw. $t = t_{-5/2}$, vergl. Fig. 3.

Neben den interpolierten Zwischenwerten enthalten die sekundären Abtastwerte ss auch die ursprünglichen Abtastwerte sp. Da das zeitdiskrete Filter 1 an seinen Ausgängen gleichzeitig mindestens drei benachbarte sekundäre Abtastwerte ausgeben muß, wird die Verzögerungskette 1.2 zwischen der ersten und zweiten Verzögerungsstufe 1.3, 1.4 und zwischen der zweiten und dritten Verzögerungsstufe 1.4, 1.5 abgegriffen und einem ersten Filterausgang 1.31 bzw. einem dritten Filterausgang 1.33 zugeführt. Somit stehen an den vier Ausgängen 1.31 bis 1.34 des zeitdiskreten Filters 1 gleichzeitig vier aufeinanderfolgende sekundäre Abtastwerte ss zur Verfügung, von denen jeweils drei dem zeitkontinuierlichen Interpolationsfilter 2 zur Bildung des jeweiligen Interpolationswertes st zugeführt sind. Die Auswahl wird durch den Mehrfachumschalter 3 bewirkt, an dessen Ausgang mindestens ein erster, zweiter oder dritter Abtastwert s1, s2, s3 abgreifbar ist. Die Abtastzeitpunkte der vier Ausgänge 1.31 bis 1.34 entsprechen in der gleichen Reihenfolge den vier absoluten Zeitpunkten $t_{-1} = -T$, $t_{-3/2} = -3T/2$, $t_{-2} = -2T$ und $t_{-5/2} = -5T/2$. Die Periodendauer $T^*$ des sekundären Abtasttaktes ist dabei $T^* = T/2$.

In einer ersten Schaltposition p1 verbindet der Mehrfachumschalter 3 die Ausgänge 1.31 bis 1.33 mit einem ersten bzw. zweiten bzw. dritten Eingang 3.11, 3.12, 3.13 des zeitkontinuierlichen Interpolationsfilters 2. Entsprechend wird in einer zweiten Schaltposition p2 eine Verbindung zwischen dem zweiten bis vierten Ausgang 1.32 bis 1.34 und den drei Eingängen 3.11 bis 3.13 hergestellt. Aus den Fig. 4 und 5 ist die Zuordnung zwischen den normierten Interpolationszeitpunkten dp = $t_{in}$/T sowie d = $t^*_{in}$/$T^*$ und den jeweils abzugreifenden sekundären Abtastwerten ss deutlich erkennbar.

Der zweite Multiplizierer 1.10 bewirkt lediglich eine Gewichtung des Ausgangssignals des dritten Addierers 1.19 mit dem Gewichtungsfaktor 1/2, der beispielsweise aus einem Datenspeicher 1.4 stammen kann. Bei einer schaltungsmäßigen Realisierung (=Hardware) wird im Fall binärcodierter Dualzahlen der zweite Multiplizierer 1.10 durch eine einfache Binärstellenverschiebung ersetzt. Der erste Multiplizierer 1.8 ist dagegen ein echter Multiplizierer, der eine Multiplikation mit einem Filterkoeffizienten b durchführt, mit dem der Frequenzgang im Durchlaßbereich bei höheren Frequenzen etwas angehoben oder abgesenkt werden kann. Der Aussteuerbereich dieses Filterkoeffizienten b ist dabei relativ klein: $- 3/8 \leq b \leq - 1/8$. Der Filterkoeffizient kann beispielsweise in einem Speicher 1.81 als fester oder von außen programmierbarer Wert gespeichert sein. In mathematischer Form kann die Übertragungsfunktion H(z) des zeitdiskreten Filters 1 zwischen den Anschlüssen 1.1 und 1.32 in der komplexen Frequenzebene wie folgt dargestellt werden:

$$H(z) = b/2 + (z^{-1} + z^{-2}) \times (1 - b) \times \tfrac{1}{2} + (z^{-3} \times b/2)$$

Das zeitkontinuierliche Interpolationsfilter 2 in Fig. 1 ist so ausgebildet, daß es mit den drei zugeführten Abtastwerten s1, s2, s3 eine Lagrange-Interpolation zweiter Ordnung durchführt. Die Impulsantwort h(t) im Zeitbereich einer derartigen Funktion läßt sich beispielsweise wie folgt angeben:

$$h(t) = ( - 1/8 + t \times t/2) \times \delta_{-1}(t) + (-9/8 + 3t - 3t^2/2) \times \delta_{-1}(t-1) +$$

$$+ (45/8 -6t + 3t^2/2) \times \delta_{-1}(t-2) + (-35/8 + 3t + t^2/2) \times \delta_{-1}(t-3)$$

Mit „$\delta_{-1}(t)$" wird eine Sprungfunktion bezeichnet, deren Übergang vom „0"- in den „1"- Zustand zum Zeitpunkt t stattfindet. Dieses Lagrange-Polynom zweiter Ordnung erlaubt über drei äquidistante Stützstellen die Bestimmung eines Interpolationswertes zum Zeitpunkt t. Dabei darf sich der Interpolationswert zeitlich nur in einem Bereich bewegen, der rechts und links von der mittleren Stützstelle den halben Stützstellenabstand aufweist, vgl. hierzu auch die Ausführungen zu den Figuren 4 und 5.

Das zeitkontinuierliche Interpolationsfilter 2 in Fig. 1 enthält eingangsseitig die drei Eingänge 3.11, 3.12 und 3.13 für die gleichzeitige Zufuhr des ersten, zweiten und dritten Abtastwertes s1, s2, s3. Der erste Eingang 3.11 ist mit dem zweiten Eingang eines vierten Addierers 3.2 und dem Minuend-Eingang eines zweiten Subtrahierers 3.3 verbunden. Der zweite Eingang 3.12 ist an einen dritten Multiplizierer 3.4 und den ersten Eingang eines fünften Addierers 3.5 angeschlossen. Der dritte Eingang 3.13 ist dem ersten Eingang des vierten Addierers 3.2 und dem Subtrahend-Eingang des zweiten Subtrahierers 3.3 zugeführt. Der Ausgang des dritten Multiplizierers 3.4 ist mit dem Subtrahend-Eingang eines dritten Subtrahierers 3.6 verbunden, dessen Minuend-Eingang vom Ausgang des vierten Addierers 3.2 gespeist ist. Der Ausgang des dritten Subtrahierers 3.6 ist auf den Eingang eines vierten Multiplizierers 3.7 geführt, desssen Ausgang mit dem ersten Eingang eines sechsten Addierers 3.8 verbunden ist, dessen zweiter Eingang am Ausgang des zweiten Subtrahierers 3.3 liegt. Der Ausgang des sechsten Addierers 3.8 speist einen fünften Multiplizierer 3.9, dessen Ausgang mit dem zweiten Eingang des fünften Addierers 3.5 verbunden ist. Der Ausgang des fünften Addierers 3.5 liefert schließlich den gesuchten Interpolationswert st. Da der dritte Multiplizierer 3.4 den zweiten Abtastwert s2 lediglich in seinem Wert zu verdoppeln hat, kann er gegebenenfalls durch eine Binärstellenverschiebung ersetzt werden. Der vierte und fünfte Multiplizierer 3.7, 3.9 fuhren jedoch echte Multiplikationen aus, nämlich mit dem auf die Periodendauer $T^*$ normierten Interpolationszeitpunkt d und seinem halben Wert d/2. Die Bildung des halben Interpolationszeitpunktes d/2 kann entweder mittels einer Binärstellenverschiebung erfolgen oder mittels eines weiteren Multiplizierers 3.10, dessen beiden Eingängen die Werte d und $\tfrac{1}{2}$ zugeführt sind, letzterer aus einem Datenspeicher 3.11.

Die Steuereinrichtung 4 enthält einen Komparator zur Bildung des Umschaltsignals ps für den Mehrfachumschalter 3. Hierfür wird entweder der absolute oder der normierte Interpelationszeitpunkt $t_{in}$ bzw. dp ausgewertet. Ferner bildet die Steuereinrichtung 4 aus den zugeführten Interpolationszeitpunkten $t_{in}$ oder dp den auf die beiden nächstliegenden sekundären Abtastwert ss, sp* und die zugehörige Periodendauer $T^*$ bezogenen Interpolationszeitpunkt d, wobei $d = t^*_{in} /T^*$ ist. Die beiden normierten Interpolationswerte dp bzw. d werden in der folgenden Beschreibung in verkürzter Form als primärer und sekundärer Interpolationszeitpunkt dp bzw. d bezeichnet. Der Zusammenhang zwischen dem Umschaltsignal ps und dem primären und sekundären Interpolationszeitpunkt dp bzw. d wird insbesondere aus der Beschreibung zu den Figuren 4 und 5 deutlich. Während der Bereich für den primären Interpolationszeitpunkt dp für eine sinnvolle Interpolation allenfalls von -1 bis +1 reicht, kann der Bereich für den sekundären Interpolationszeitpunkt d, der von -0,5 bis +0,5 geht, nur Teilbereiche davon erfassen, die sich überlappungsfrei aneinander anschließen. Entsprechend der ersten und zweiten Schaltposition p1, p2 sind in Fig. 5 die resultierenden Interpolationsbereiche p1, p2 neben der Zeitachse für die primären Interpolationszeitpunkte dp angegeben.

Wenn für den primären Interpolationszeitpunkt dp nur negative oder positive Zeitbereiche zugelassen sind, dann erstrecken sich diese zwischen $0 \leq dp \leq 1$ bzw. $-1 \leq p \leq 0$. Dabei kann ebenfalls jeder zeitliche Zwischenwert zwischen zwei primären Abtastzeitpunkten $t_0$, $t_{-1}$, $t_{-2}$, ... realisiert werden. Die jeweils zusammengehörigen Bereiche für die Umschaltsignale ps sind aus den in Fig. 5 angegebenen Schaltpositionen p1, p2 ersichtlich.

Für jeden beliebigen Interpolationszeitpunkt $t_{in}$ innerhalb einer Periodendauer T kann aber auch interpoliert werden, wenn für den primären Interpolationszeitpunkt dp ein symmetrisches Zeitintervall $-0,5 \leq dp \leq +0,5$ oder ein unsymmetrisches Zeitintervall $-0,25 \leq dp \leq +0,75$ vorgegeben wird. Im ersten Fall sind drei unterschiedliche Schaltpositionsbereiche p1, p2, p1 erforderlich, im zweiten Fall nur die beiden Schaltpositionsbereiche p1, p2. Jeder einzelnen Schaltposition sind jeweils andere sekundäre Abtastwerte ss zugeordnet, im ersten Fall sind es drei und im zweiten Fall zwei Dreiergruppen. Bei einem eingeschränkten Interpolationsintervall reicht gegebenenfalls eine einzige Dreiergruppe aus. In diesem Fall kann der Mehrfachumschalter 3 entfallen.

Die Steuereinrichtung 4 bildet den sekundären Interpolationszeitpunkt d aus dem primären Interpolationszeitpunkt dp entweder aus einer gespeicherten Tabelle oder durch eine einfache Modulo-Rechnung $d = dp +/- j$, wobei $j = 1, 2, 3.....$ so vorzugeben ist, daß der Bereich $-0,5 \leq d \leq +0,5$ nicht überschritten wird. Bei der Definition sämtlicher Bereichsgrenzen sind Mehrdeutigkeiten zu vermeiden, wobei die Gegebenheiten des jeweiligen Zahlensystems möglichst zu beachten sind. Bei dem Zweierkomplement-Zahlensystem schließt der positive Wertebereich beispielsweise die Zweierpotenzen $2^n$ als erreichbare Grenzwerte aus.

In Fig. 2 ist schematisch im Zeitdiagramm das analoge Signal sg dargestellt, das zu den Zeitpunkten $t_{-3}$ bis $t_1$ abgetastet ist. Die resultierenden primären Abtastwerte sp stellen eine digitalisierte Datenfolge dar. Die Periodendauer T der primären Abtastrate ist dabei konstant. Die Zeitachse kann daher auch auf die Periodendauer T normiert werden, wodurch normierte Zeitwerte dp gebildet werden, denen in Fig. 2 die Indexwerte der Zeiten t entsprechen. Die Vorgabe normierter Zeitwerte dp ist zur Bildung des gesuchten Interpolationswertes st von Vorteil. In Fig. 2 sind zeitlich äquidistante Interpolationswerte st1, st2, st3 dargestellt, die beispielsweise einer neuen Abtastfolge zugeordnet sein können. Die zugehörige Periodendauer Ts kann dabei in einem beliebigen Zahlenverhältnis zur ursprünglichen Periodendauer T stehen.

In Fig. 3 ist im Zeitdiagramm eine Folge aus sekundären Abtastwerten ss dargestellt, die beispielweise durch das zeitdiskrete Filter 1 von Fig. 1 gebildet werden können. Gegenüber der primären Abtastfolge hat sich die Periodendauer $T^*$ der sekundären Abtastfolge halbiert, also $T^* = T/2$. In der sekundären Abtastfolge sind die ursprünglichen Abtastwerte sp enthalten, in den Figuren 3 bis 5 sind diese Abtastwerte mit $sp^*$ bezeichnet.

Der Interpolationszeitpunkt $t^*_{in}$ in Fig. 3 ist bezüglich des Signals sg identisch zum Interpolationszeitpunkt $t_{in}$ von Fig. 2. Durch das „*" soll angedeutet werden, daß der Interpolationszeitpunkt bei der sekundären Abtastfolge jeweils auf den nächstliegenden sekundären Abtastwert ss zu beziehen ist, der in Fig. 3 identisch mit dem primären Abtastsignal $sp^*$ ist.

Für die Interpolation im zeitkontinuierlichen Interpolationsfilter 2 von Fig. 1 werden nun jeweils drei benachbarte sekundäre Abtastwerte ss weiterverarbeitet, wobei die Auswahl so vorgenommen wird, daß der Interpolationszeitpunkt $t^*_{in}$ möglichst dicht bei einem sekundären Abtastzeitpunkt liegt. Beispiele für eine derartige sekundäre Abtastgruppe aus drei Abtastwerten ss sind in Fig. 4 und Fig. 5 dargestellt, wobei in Fig. 4 der zulässige Interpolationsbereich $t^*_{in}$ symmetrisch um den sekundären Abtastwert ss zum Zeitpunkt $t_{3/2}$ liegt und in Fig. 4 symmetrisch um den primären Abtastwert $sp^*$ zum Zeitpunkt $t_2$.

Die Auswahl der Abtastzeitpunkte entsprechend Fig. 4 oder Fig. 5 erfolgt in dem Schaltungsbeispiel von Fig. 1 durch den Mehrfachumschalter 3 in Verbindung mit der Steuereinrichtung 4. Die zeitliche Eingrenzung des jeweiligen Interpolationsbereiches $t^*_{in}$ ergibt sich aus der Interpolationsfunktion des zeitkontinuierlichen Filters 2. Die Interpolationswerte st, die außerhalb des optimalen Interpolationsintervalls $-1/2 \leq d \leq +1/2$ liegen, haben größere Abweichungen vom tatsächlichen Signalverlauf sg als diejenigen Interpolationswerte sp, die innerhalb des angegebenen Intervalls liegen. Es ist daher sinnvoll, von der sekundären Abtastfolge immer nur diejenigen drei Abtastwerte ss zu verwenden, die am dichtesten beim Interpolationszeitpunkt $t_{in}$ liegen.

Das Zeitdiagramm von Fig. 4 entspricht der Schaltposition p1 des Mehrfachumschalters 3, und das Zeitdiagramm von Fig. 5 entspricht der Schaltposition p2. Unterhalb der Zeitachse von Fig. 5 ist eine weitere Zeitachse aufgetragen, die dem primären Interpolationszeitpunkt dp entspricht. Für die praktische Anwendung der Interpolationsschaltung nach der Erfindung kann es beispielsweise erwünscht sein, daß sich der Interpolationszeitpunkt $t_{in}$ über zwei Perioden T erstreckt, nämlich von einem vorgegebenen Abtastzeitpunkt aus zum vorangehenden und nachfolgenden Abtastzeitpunkt. Dem entspricht der Wertebereich von -1 bis +1 für den primären Interpolationszeitpunkt dp. Über der zugehörigen Zeitachse dp in Fig. 5 sind die zugehörigen Schaltpositionen p1, p2 angegeben. Die zugehörigen sekundäre Abtastwerte ss sind dabei nur für die Zeitbereiche von Fig. 4 und Fig. 5 dargestellt. Außerhalb dieser Zeitbereiche sind andere Dreierfolgen der sekundären Abtastwerte ss für die zeitkontinuierliche Interpolation im Filter 2 zu verwenden.

**Patentansprüche**

1. Digitale Filterkombination zur zeitlichen Interpolation von primären Abtastwerten (sp) eines abgetasteten Signals (sg) mit einem zeitdiskreten Filter (1) m-ter Ordnung und einem zeitkontinuierlichen Interpolationsfilter (2) k-ter Ordnung, wobei $m \geq 3$ und $k \geq 2$ ist,

   - das zeitdiskrete Filter (1) bildet aus mindestens $m + 1$ primären Abtastwerten (sp) in zeitlich äquidistanten Abständen (T*; T/2) n sekundäre Abtastwerte (ss), dabei ist n ≥ m, und

- das zeitkontinuierliche Interpolationsfilter (2) bildet aus mindestens einem Teil der n sekundären Abtastwerte (ss) einen Interpolationswert (st), dessen zeitliche Lage bezüglich derjenigen der primären Abtastwerte (sp) durch einen normierten Interpolationszeitpunkt dp = $t_{in}$/T vorgebbar ist, wobei $t_{in}$ der absolute Interpolationszeitpunkt und T die Periodendauer der primären Abtastrate sind.

2. Filterkombination nach Anspruch 1, dadurch gekennzeichnet, daß das zeitdiskrete Filter (1) ein Filter dritter Ordnung ist, dessen sekundären Abtastwerte (ss) unter Einschluß der primären Abtastwerte (sp*) einer sekundären Abtastfolge entsprechen, deren Datenrate doppelt so groß ist wie diejenige der primären Abtastwerte (sp), wobei das zeitdiskrete Filter ausgangsseitig mindestens k sekundäre Abtastwerte (ss) für das zeitkontinuierliche Interpolationsfilter (2) zur Verfügung stellt.

3. Filterkombination nach Anspruch 2, dadurch gekennzeichnet, daß das zeitdiskrete Filter (1) durch folgende Merkmale gekennzeichnet ist:

- eine Verzögerungskette (1.2), die mindestens aus einer ersten, zweiten und dritten Verzögerungsstufe (1.21, 1.22, 1.23) gebildet ist, deren jeweilige Verzögerung gleich der Periodendauer T der primären Abtastrate ist,

- der Eingang der ersten Verzögerungsstufe (1.21) liegt am ersten Eingang eines ersten Addierers (1.5), und deren Ausgang am ersten Eingang eines zweiten Addierers (1.6), mit dessen zweitem Eingang der Eingang der dritten Verzögerungsstufe (1.23) verbunden ist, deren Ausgang am zweiten Eingang des ersten Addierers (1.5) liegt.

- der Ausgang des ersten Addierers (1.5) ist mit dem Minuend-Eingang und der Ausgang des zweiten Addierers (1.6) mit dem Subtrahend-Eingang eines ersten Subtrahierers (1.7) verbunden, dessen Ausgang über einen ersten Multiplizierer (1.8) mit dem ersten Eingang eines dritten Addierers (1.9) verbunden ist, dessen zweiter Eingang am Ausgang des zweiten Addierers (1.6) und dessen Ausgang über einen zweiten Multiplizierer (1.10) an einem zweiten Ausgang (1.32) und über eine vierte Verzögerungsstufe (1.11), die eine Verzögerung um die Periodendauer T der primären Abtastrate bewirkt, an einem vierten Ausgang (1.34) des zeitdiskreten Filters (1) liegt, und

- ein Abgriff zwischen der ersten und zweiten Verzögerungsstufe (1.21, 1.22) ist einem ersten (1.31) und ein Abgriff zwischen der zweiten und dritten Verzögerungsstufe (1.22, 1.23) ist einem dritten Ausgang (1.31 bzw. 1.33) des zeitdiskreten Filters (1) zugeführt.

4. Filterkombination nach einem der Ansprüche 1 bis 3, dadurch gekennzeichnet, daß das zeitkontinuierliche Interpolationsfilter (2) eine Lagrange-Interpolation zweiter Ordnung realisiert.

5. Filterkombination nach Anspruch 4, bei der das zeitkontinuierliche Interpolationsfilter (2) durch folgende Merkmale gekennzeichnet ist:

- vom zeitdiskreten Filter (1) ist das zeitkontinuierliche Interpolationsfilter (2) eingangsseitig an einem ersten, zweiten und dritten Eingang (3.11, 3.12, 3.13) mit den sekundären Abtastwerten (ss) der normierten Zeitpunkte dp = -1, -3/2, -2 oder dp = -3/2, -2, -5/2 gespeist, die einen ersten, zweiten und dritten Abtastwert (s1, s2, s3) definieren,

- der erste Abtastwert (s1) ist dem zweiten Eingang eines vierten Addierers (3.2) und dein Minuend-Eingang eines zweiten Subtrahieres (3.3) zugeführt,

- der zweite Abtastwert (s2) ist einem dritten Multiplizierer (3.4) und dem ersten Eingang eines fünften Addierers (3.5) zugeführt,

- der dritte Abtastwert (s3) ist dem ersten Eingang des vierten Addierers (3.2) und dem Subtrahend-Eingang des zweiten Subtrahierers (3.3) zugeführt,

- der Ausgang des dritten Multiplizierers (3.4) ist mit dem Subtrahend-Eingang eines dritten Subtrahierers (3.6) verbunden, dessen Minuend-Eingang vom Ausgang des vierten Addierers (3.2) gespeist ist,

- der Ausgang des dritten Subtrahierers (3.6) ist auf den Eingang eines vierten Multiplizierers (3.7) geführt, dessen Ausgang mit dem ersten Eingang eines sechsten Addierers (3.8) verbunden ist, dessen zweiter Eingang am Ausgang des zweiten Subtrahierers (3.3) liegt,

- der Ausgang des sechsten Addierers (3.8) speist einen fünften Multiplizierer (3.9), dessen Ausgang mit dem zweiten Eingang des fünften Addierers (3.5) verbunden ist,

- der dritte Multiplizierer (3.4) führt eine Festmultiplikiaition mit dem Faktor 2 aus und

- der vierte bzw. fünfte Multiplizierer (3.7, 3.9) multipliziert die zugeführten Datenwerte mit dem Wert eines normierten sekundären Interpolationszeitpunktes d bzw. d/2, wobei der normierte sekundäre Interpolationszeitpunkt d durch Normierung eines sekundären Interpolationszeitpunktes $t^*_{in}$ auf die sekundäre Abtastrate $T^*$ mit $d = t^*_{in}/T^*$ gebildet ist und der sekundäre Interpolationszeitpunkt $t^*_{in}$ auf den nächstliegenden sekundären Abtastwert (ss, sp*) bezogen ist.

6. Filterkombination nach mindestens einem der Ansprüche 1 bis 5, dadurch gekennzeichnet, daß zwischen die Ausgänge (1.31 bis 1.34) des zeitdiskreten Filters (1) und die Eingänge (3.11, 3.12, 3.13) des zeitkontinuierlichen Interpolationsfilters (2) ein vom normierten Interpolationszeitpunkt dp gesteuerter Mehrfachumschalter (3) eingefügt ist, wobei dieser mindestens eine erste und eine zweite Schaltposition (p1, p2) aufweist.

7. Filterkombination nach Anspruch 6, dadurch gekennzeichnet, daß in der ersten Schaltposition (p1), der erste, der zweite und dritte Ausgang (1.31, 1.32, 1.33) und in der zweiten Schaltposition (p2) der zweite, dritte und vierte Ausgang (1.32, 1.33, 1.34) des zeitdiskreten Filters (1) mit dem ersten, zweiten und dritten Eingang (3.11, 3.12, 3.13) des zeitkontinuierlichen Interpolationsfilters (2) in der angegebenen Zuordnung verbunden sind.

Fig.1

Fig.2

Fig.3

Fig.4

$$d = t_{in}^* / T^*$$

Fig.5

Europäisches
Patentamt

**EUROPÄISCHER RECHERCHENBERICHT**

Nummer der Anmeldung

EP 96 11 9505

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | EP 0 262 647 A (TOKYO SHIBAURA ELECTRIC CO) 6.April 1988 | 1 | G06F17/17 |
| A | * Zusammenfassung; Anspruch 1; Abbildung 11 * | 2-7 | |
| A | EP 0 220 880 A (SONY CORP) 6.Mai 1987 * Anspruch 1 * | 1-7 | |
| A | US 4 703 353 A (DAVID MORGAN W A) 27.Oktober 1987 | | |
| A | US 4 862 271 A (SMITH TERRENCE R  ET AL) 29.August 1989 | | |
| A | ELECTRONICS LETTERS, Bd. 26, Nr. 19, 13.September 1990, Seiten 1608-1610, XP000106903 LIU G -S ET AL:  "PROGRAMMABLE FRACTIONAL SAMPLE DELAY FILTER WITH LAGRANGE INTERPOLATION" * das ganze Dokument * | 4 | |

|  |  |  | **RECHERCHIERTE SACHGEBIETE (Int.Cl.6)** |
|---|---|---|---|
|  |  |  | G06F |

Der vorliegende Recherchenbericht wurde für alle Patentansprüche erstellt

| Recherchenort | Abschlußdatum der Recherche | Prüfer |
|---|---|---|
| DEN HAAG | 16.Juni 1997 | Pierfederici, A |

KATEGORIE DER GENANNTEN DOKUMENTE

X : von besonderer Bedeutung allein betrachtet
Y : von besonderer Bedeutung in Verbindung mit einer
 anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
 nach dem Anmeldedatum veröffentlicht worden ist
D : in der Anmeldung angeführtes Dokument
L : aus andern Gründen angeführtes Dokument
..........................................................................
& : Mitglied der gleichen Patentfamilie, übereinstimmendes
 Dokument

EPO FORM 1503 03.82 (P04C03)